# EUROPÄISCHE PATENTANMELDUNG

(11) **EP 4 611 176 A1**
(43) Veröffentlichungstag der Anmeldung: **03.09.2025**
(21) Anmeldenummer: 24160276.2
(22) Anmeldetag: 28.02.2024
(51) Int. Cl.: H01R 4/34, H01R 12/57, H01R 12/58, H05K 1/18, H05K 5/00, H01R 11/01, H01R 12/70, H01R 12/72

(54) **VERBINDUNGSSTÜCK ZUM VERBINDEN ZUMINDEST ZWEIER ELEKTRISCHER KONTAKTE, LEISTUNGSMODUL UND ELEKTRISCHES GERÄT**

(71) Anmelder: Siemens Aktiengesellschaft, 80333 München (DE)
(72) Erfinder: Konnerth, Philipp, 96052 Bamberg (DE); Mittelmaier, Frederik, 91056 Erlangen (DE); Panicerski, Stanislav, 90449 Nürnberg (DE); Stumpf, Alexander, 91126 Schwabach (DE)
(74) Vertreter: Siemens Patent Attorneys

(57) **Zusammenfassung**

Die Erfindung betrifft Verbindungsstück (1) zum Verbinden zumindest zweier elektrischer Kontakte, ein Leistungsmodul (12) aufweisend zumindest ein derartiges Verbindungsstück (1) und ein elektrisches Gerät (20) aufweisend zumindest ein derartiges Leistungsmodul (12).

Insb. um ein kostengünstiges und einfach zu montierendes Verbindungsstück (1) bereitzustellen, wird vorgeschlagen, dass das Verbindungsstück (1) aufweist:
• eine Grundplatte (2), welche sich in der x-y-Ebene erstreckt und eine Dicke dg in z-Richtung aufweist,
wobei die Grundplatte (2) zumindest abschnittsweise eine erste elektrische Kontaktfläche (21) aufweist,
wobei die Grundplatte (2) zwei Laschen (4a, 4b) aufweist, von denen die erste Lasche (4a) in positiver x-Richtung und die zweite Lasche (4b) in negativer x-Richtung aus der Grundplatte (2) herausragt,
wobei die beiden Laschen (4a, 4b) weiterhin in positiver z-Richtung aus der Grundplatte (2) herausragen,

• ein Übergangsstück (5), welches in Verlängerung in y-Richtung an der Grundplatte (2) angeordnet ist, und
• eine Nebenplatte (6),
wobei die Nebenplatte (6) in Verlängerung in y-Richtung an dem Übergangsstück (5) angeordnet ist,
wobei die Nebenplatte (6) über das Übergangsstück (5) mit der Grundplatte (2) verbunden ist,
wobei die Nebenplatte (6) sich in der x-y-Ebene erstreckt, um einen Versatz V in positiver z-Richtung gegenüber der Grundplatte (2) versetzt ist und eine Dicke dn in z-Richtung aufweist,
wobei die Nebenplatte (6) zumindest abschnittsweise eine zweite elektrische Kontaktfläche (10) aufweist.

## Beschreibung

### Technisches Gebiet

Die Erfindung betrifft Verbindungsstück zum Verbinden zumindest zweier elektrischer Kontakte, ein Leistungsmodul aufweisend zumindest ein derartiges Verbindungsstück und ein elektrisches Gerät aufweisend zumindest ein derartiges Leistungsmodul.

### Technischer Hintergrund

Verbindungsstück zum Verbinden zumindest zweier elektrischer Kontakte, entsprechende Leistungsmodule und elektrische Geräte sind aus einer Vielzahl von Anwendungen, bspw. in der Leistungselektronik, bekannt. Derartige Verbindungsstücke stellen bspw. elektrische Kontakte innerhalb des Leistungsmoduls her und sind vorzugsweise kostengünstig und einfach zu montieren.

### Zusammenfassung der Erfindung

Insbesondere für eine verbesserte Montage wird ein Verbindungsstück der eingangs genannten Art vorgeschlagen, welches
- eine Grundplatte, welche sich in der x-y-Ebene erstreckt und eine Dicke dg in z-Richtung aufweist, wobei die Grundplatte zumindest abschnittsweise eine erste elektrische Kontaktfläche aufweist, wobei die Grundplatte zwei Laschen aufweist, von denen die erste Lasche in positiver x-Richtung und die zweite Lasche in negativer x-Richtung aus der Grundplatte herausragt, wobei die beiden Laschen weiterhin in positiver z-Richtung aus der Grundplatte herausragen,
- ein Übergangsstück, welches in Verlängerung in y-Richtung an der Grundplatte angeordnet ist, und
- eine Nebenplatte aufweist,
   wobei die Nebenplatte in Verlängerung in y-Richtung an dem Übergangsstück angeordnet ist, wobei die Nebenplatte über das Übergangsstück mit der Grundplatte verbunden ist, wobei die Nebenplatte sich in der x-y-Ebene erstreckt, um einen Versatz V in positiver z-Richtung gegenüber der Grundplatte versetzt ist und eine Dicke dn in z-Richtung aufweist, und wobei die Nebenplatte zumindest abschnittsweise eine zweite elektrische Kontaktfläche aufweist.

Weiterhin wird ein Leistungsmodul der eingangs genannten Art vorgeschlagen, welches
- eine Leiterplatte, welche sich in der x-y-Ebene erstreckt und eine Dicke dl in z-Richtung aufweist, wobei die Leiterplatte zumindest eine erste Leiterplatten-Aussparung aufweist,
- zumindest ein Halbleiter-Bauelement, welches sich jeweils in der x-y-Ebene erstreckt und in negativer z-Richtung versetzt zur Leiterplatte angeordnet ist,
- zumindest ein Verbindungsstück nach einem der vorhergehenden Ansprüche und
- zumindest ein Anschlusselement aufweist,
wobei das jeweilige Verbindungsstück derart angeordnet ist, dass
- die jeweilige Grundplatte in der jeweiligen ersten Leiterplatten-Aussparung angeordnet ist und die jeweiligen beiden Laschen jeweils zumindest abschnittsweise auf der Leiterplatte in z-Richtung aufliegen,
- die jeweilige Nebenplatte zumindest abschnittsweise auf der Leiterplatte in z-Richtung aufliegt,
- das jeweilige Anschlusselement mit der jeweiligen ersten elektrischen Kontaktfläche verbunden ist, und
- die jeweilige zweite elektrische Kontaktfläche mit dem jeweiligen Halbleiter-Bauelement verbunden ist.

Ferner wird ein elektrisches Gerät, insbesondere ein Umrichter, der eingangs genannten Art vorgeschlagen, welches zumindest ein derartiges Leistungsmodul aufweist.

### Ausgestaltungen der Erfindung

Zum Verbinden der zumindest zwei elektrischen Kontakte weist das vorgeschlagene Verbindungsstück die erste elektrische Kontaktfläche und die zweite elektrische Kontaktfläche auf, wobei die erste elektrische Kontaktfläche auf der Grundplatte angeordnet ist und bspw. in die positive z-Richtung weist und wobei die zweite elektrische Kontaktfläche auf der Nebenplatte angeordnet ist und bspw. in die negative z-Richtung weist. Dabei sind die Grundplatte und die Nebenplatte über das Übergangsstück miteinander verbunden, sodass entlang der y-Richtung zunächst die Grundplatte, dann das Übergangsstück und dann die Nebenplatte angeordnet sind.

Die Grundplatte und die Nebenplatte erstrecken sich dabei in der x-y-Ebene, sind vorzugsweise flach ausgeführt und weisen insbesondere eine vergleichsweise geringe jeweilige Dicke in z-Richtung gegenüber ihren jeweiligen Ausmaßen in der x-y-Ebene auf. Dabei ist die Nebenplatte in der positiven z-Richtung gegenüber der Grundplatte versetzt.

Insbesondere für eine erleichterte Montage des Verbindungsstücks weist die Grundplatte die zwei Laschen auf, von denen die erste Laschen in positiver x-Richtung und die zweite Lasche in negativer x-Richtung herausragt. Die beiden Laschen ragen dabei weiterhin in positiver z-Richtung aus der Grundplatte heraus.

Von Vorteil ist bei dem vorgeschlagenen Verbindungsstück insbesondere, dass dank des Versatzes in z-Richtung zwischen der Grundplatte und der Nebenplatte Höhenunterschiede ausgeglichen werden können, welche bspw. auf jenem Element eines Leistungsmoduls auftreten können, auf welchem das vorgeschlagenen Verbindungsstück zur elektrischen Kontaktierung anzubringen ist. Bei dem genannten Element kann es sich bspw. um eine Leiterplatte oder ein Halbleiter-Bauelement des Leistungsmoduls handeln. Ferner sind die beiden Laschen bei der Montage des Verbindungsstücks von Vorteil, da sie bspw. in ein passendes Gegenstück insb. innerhalb eines Leistungsmoduls eingreifen können, in welches das vorgeschlagene Verbindungstück eingebaut wird. Insbesondere durch die beiden Laschen kann eine Positionierung bzw. Zentrierung des vorgeschlagenen Verbindungsstücks bezüglich einer gewünschten Position des vorgeschlagenen Verbindungsstücks innerhalb eines Leistungsmoduls erreicht werden.

Bei einer vorteilhaften Ausgestaltung der Erfindung weist die erste Lasche einen ersten männlichen Laschenabschnitt auf, welcher zumindest abschnittsweise schräg in positiver x-Richtung und positiver z-Richtung verläuft, wobei die zweite Lasche einen zweiten männlichen Laschenabschnitt aufweist, welcher zumindest abschnittsweise schräg in negativer x-Richtung und positiver z-Richtung verläuft.

Die jeweilige Lasche weist somit jeweiligen Längsabschnitt auf, welcher schräg von der übrigen Grundplatte aus nach außen und in positiver z-Richtung weist. Somit verläuft der erste Längsabschnitt schräg in positiver x-Richtung und positiver z-Richtung und der zweite Längsabschnitt schräg in negativer x-Richtung und positiver z-Richtung. Dabei wird der jeweilige Längsabschnitt als männlich bezeichnet, da er insbesondere in ein jeweils passend ausgebildetes, weibliches Gegenstück eingreifen kann, ähnlich wie bei einer Nut-Feder-Verbindung.

Dank der beiden Längsabschnitte ist eine besonders leichte und genaue Positionierung bzw. Zentrierung des vorgeschlagenen Verbindungsstücks bezüglich einer gewünschten Position des vorgeschlagenen Verbindungsstücks innerhalb eines Leistungsmoduls erreichbar.

Da die jeweilige Lasche an ihrem Längsabschnitt insb. eine konstruktive Winkelform aufweist, kann eine Federwirkung bewirkt werde, wodurch die jeweilige Lasche beim Befestigen, bspw.

Verschrauben, des Verbindungsstücks nachgibt und somit ausreichend Spiel für die Montage ermöglicht wird.

Bei einer weiteren vorteilhaften Ausgestaltung der Erfindung weist die Grundplatte eine in z-Richtung durchgehende Grundplatten-Aussparung auf.

Bspw. kann die Grundplatten-Aussparung derart ausgestaltet sein, dass sie durch die Grundplatte in z-Richtung hindurch geht. Dabei kann die Grundplatten-Aussparung insbesondere mittig angeordnet sein.

Durch die Grundplatten-Aussparung kann bspw. ein Verbindungselement durch die Grundplatte hindurchgeführt werden, wobei das Verbindungselement dabei die Grundplatte zumindest an der ersten elektrischen Kontaktfläche berührt und damit mit der Grundplatte elektrisch kontaktiert ist. Beispielsweise ist die erste elektrische Kontaktfläche zumindest teilweise an der Innenseite der Grundplatten-Aussparung angeordnet. Insb. wenn das Verbindungselement in z-Richtung auf der Grundplatte aufliegt, ist zumindest ein Teil der ersten elektrischen Kontaktfläche an jener Oberfläche der Grundplatte angeordnet, welche in die positive z-Richtung weist.

Die Grundplatten-Aussparung erlaubt insb. eine gute elektrische Kontaktierung des Verbindungsstücks und ermöglicht somit die Übertragung vergleichsweise großer elektrischer Ströme.

Bei einer weiteren vorteilhaften Ausgestaltung der Erfindung weist die Grundplatte zumindest abschnittsweise eine in negative z-Richtung weisende dritte elektrische Kontaktfläche auf.

Dank der dritten elektrischen Kontaktfläche, die in die negative z-Richtung weist, können eine verbesserte elektrische Kontaktierung des Verbindungsstücks, insb. über die Grundplatte, und die Übertragung vergleichsweise großer elektrischer Ströme erreicht werden.

Bei einer weiteren vorteilhaften Ausgestaltung der Erfindung weist die Nebenplatte zumindest abschnittsweise eine in positive z-Richtung weisende Transportoberfläche auf, welche zum vollautomatischen Bestücken auf Leiterplatten oder anderen Trägersubstraten mittels eines Bestückungsautomaten geeignet ist.

Vorzugsweise ist die Transportoberfläche plan und derart gestaltet, dass ein Bestückungsautomat das Verbindungsstück insb. mittels Saugen von einer Startposition in eine Zielposition bewegen kann. Bspw. kann vorgesehen sein, dass der Bestückungsautomat das Verbindungsstück auf oder in einem Bauteil eines Leistungsmoduls positioniert, bspw. einer Leiterplatte eines Leistungsmoduls. Hierzu kann der Bestückungsautomat das Verbindungsstück an der Startposition über die Transportoberfläche bspw. ansaugen und dann an der Zielposition ablegen bzw. dort fixieren.

Bei einer weiteren vorteilhaften Ausgestaltung der Erfindung weist die Nebenplatte zumindest einen Verbindungsbügel auf, welcher jeweils in negativer z-Richtung aus der Nebenplatte herausragt und welcher zumindest abschnittsweise von der zweiten elektrischen Kontaktfläche umfasst ist.

Das Herausragen des jeweiligen Verbindungsbügels aus der Nebenplatte ist dabei insb. derart zu verstehen, dass der jeweilige Verbindungsbügel entsprechend aus der übrigen, insbesondere eher flach ausgestalteten und sich in der x-y-Ebene erstreckenden Nebenplatte herausragt. Insbesondere ragt der jeweilige Verbindungsbügel weiter als die Dicke der übrigen Nebenplatte aus der übrigen Nebenplatte heraus.

Der jeweilige Verbindungsbügel trägt dabei zur elektrischen Kontaktierung des Verbindungsstücks bei. Insbesondere können dabei zwei oder mehr derartiger Verbindungsbügel vorgesehen sein. Bspw. bildet der Verbindungsbügel bzw. bilden die Verbindungsbügel die zweite elektrische Kontaktfläche. In manchen Beispielen umfasst die zweite Kontaktfläche einen oder mehrere solcher Verbindungsbügel und weiterhin einen Abschnitt jener Oberfläche der übrigen Nebenplatte, welche in die negative z-Richtung weist, wobei die genannte Oberfläche bspw. flach ausgestattet sein kann und insb. zum Verlöten geeignet sein kann.

Bei manchen Verwendungen des Verbindungsstückes in einem Leistungsmodul ragt der jeweilige Verbindungsbügel soweit aus der übrigen Nebenplatte in negativer z-Richtung heraus, dass der jeweilige Verbindungsbügel durch eine Leiterplatte des Leistungsmoduls hindurch ein Halbleiter-Bauelement des Leistungsmoduls elektrisch kontaktieren kann, wobei bei einem derartigen Leistungsmodul in negativer z-Richtung zunächst die flach ausgestaltete, übrige Nebenplatte, dann die Leiterplatte und schließlich das Halbleiter-Bauelement des Leistungsmoduls angeordnet sind.

Bei einer weiteren vorteilhaften Ausgestaltung der Erfindung ist die zweite elektrische Kontaktfläche zum Löten geeignet, wobei der jeweilige Verbindungsbügel als Lötpin ausgestaltet ist. Insbesondere kann die Nebenplatte um den jeweiligen Verbindungsbügel herum in der x-y-Ebene eine U-förmige Nebenplatten-Aussparung aufweisen. Beispielsweise kann der jeweilige Verbindungsbügel mittels Stanzen und Biegen aus der Nebenplatte ausgeformt werden, wobei die jeweilige U-förmige Nebenplatten-Aussparung um den jeweiligen Verbindungsbügel herum ausgestanzt wird.

Bei einer weiteren vorteilhaften Ausgestaltung der Erfindung weist die Nebenplatte zumindest eine in z-Richtung durchgehende zweite Nebenplatten-Aussparung auf.

Bspw. kann die Nebenplatten-Aussparung insbesondere mittig angeordnet sein.

Durch die Nebenplatten-Aussparung kann bspw. ein weiteres Verbindungselement durch die Nebenplatte hindurchgeführt werden. Das weitere Verbindungselement kann dabei die Nebenplatte an jener Oberfläche der Nebenplatte berühren, welche in die positive z-Richtung weist. Das weitere Verbindungselement kann die Nebenplatte insb. an der zweiten elektrischen Kontaktfläche bzw. teilweise an der Innenseite der Nebenplatten-Aussparung berühren und damit elektrisch kontaktieren.

Die Nebenplatten-Aussparung erlaubt insb. eine gute elektrische Kontaktierung des Verbindungsstücks mit einem in negativer z-Richtung zu der Nebenplatte versetzten Bauteil, insbesondere einem Halbleiter-Bauelement eines Leistungsmoduls. Insb. dadurch, dass die Nebenplatte mit dem Halbleiter-Bauelement verschraubt wird oder auf das Halbleiter-Bauelement gedrückt wird, wird die Übertragung vergleichsweise großer elektrischer Ströme ermöglicht.

Bspw. kann das weitere Verbindungselement als Bolzen o.ä. ausgestaltet sein.

Insb. kann die Grundplatte in der x-y-Ebene eine größere Fläche aufweisen als die Nebenplatte.

Die Leiterplatte des vorgeschlagenen Leistungsmoduls erstreckt sich in der x-y-Ebene, ist vorzugsweise flach ausgeführt und weist insbesondere eine vergleichsweise geringe Dicke in z-Richtung gegenüber ihren jeweiligen Ausmaßen in der x-y-Ebene auf. Dabei ist die Leiterplatte in negativer z-Richtung insb. gegenüber dem flachen Teil der Nebenplatte des jeweiligen Verbindungsstücks versetzt, wobei die Nebenplatte des jeweiligen Verbindungsstücks zumindest abschnittsweise auf der Leiterplatte in z-Richtung aufliegt.

Die erste Leiterplatten-Aussparung ist dabei derart ausgebildet, dass darin die Grundplatte des jeweiligen Verbindungsstücks angeordnet werden kann. Dabei ermöglichen die beiden Laschen des jeweiligen Verbindungsstücks eine gute Positionierung bzw. Zentrierung des jeweiligen Verbindungsstücks in bzw. auf der Leiterplatte und somit dem übrigen Leistungsmodul. Weiterhin werden insb. durch die Laschen die Produktionstoleranzen der Leiterplatte ausgeglichen.

Das jeweilige Anschlusselement kann bspw. als Bolzen, Schraube, Stromschiene oder generell als stromführendes Element ausgeführt sein und ist mit der ersten elektrische Kontaktfläche des jeweiligen Verbindungsstücks elektrisch verbunden, bspw. indem es die erste elektrische Kontaktfläche berührt bzw. mit dieser verbunden ist. Weiterhin ist die zweite elektrische Kontaktfläche des jeweiligen Verbindungsstücks mit dem jeweiligen Halbleiter-Bauelement elektrisch verbunden.

Somit wird durch das jeweilige Verbindungsstück eine elektrische Verbindung einerseits über die jeweilige erste elektrische Kontaktfläche mit dem jeweiligen Anschlusselement und andererseits über die zweite elektrische Kontaktfläche mit dem jeweiligen Halbleiter-Bauelement erreicht. Dank der beiden Laschen des jeweiligen Verbindungsstücks kann das jeweilige Verbindungsstück während der Montage leicht und zielgenau innerhalb des restlichen Leistungsmoduls positioniert und fixiert werden.

Bei dem jeweiligen Halbleiter-Bauelement kann es sich bspw. um eine Diode oder einen Transistor, insb. einen IGBT (Bipolartransistor mit isolierter Gate-Elektrode, englisch insulated-gate bipolar transistor), handeln.

Bei einer weiteren vorteilhaften Ausgestaltung der Erfindung weist die Leiterplatte dort eine erste weibliche Einkerbung in positiver x-Richtung aufweist, wo der erste männliche Laschenabschnitt die Leiterplatte berührt, und wobei die Leiterplatte dort eine zweite weibliche Einkerbung in negativer x-Richtung aufweist, wo der zweite männliche Laschenabschnitt die Leiterplatte berührt.

Für diese Ausgestaltung des Leistungsmoduls wird die oben erläuterte Ausgestaltung des Verbindungsstücks mit den beiden männlichen Laschenabschnitten verwendet. Die Leiterplatte weist insb. an der ersten Leiterplatten-Aussparung zwei passen ausgebildete, weibliche Gegenstücke auf, in welche die beiden männlichen laschen Abschnitte eingreifen können. Insbesondere befinden sich die beiden weiblichen Einkerbungen am Rand der ersten Leiterplatten-Aussparung, und zwar die erste weibliche Einkerbung am Rand der Leiterplatten-Aussparung in positiver x-Richtung und die zweite weibliche Einkerbung am Rand der Leiterplatten-Aussparung in negativer x-Richtung. Dabei sind der jeweilige männliche Laschenabschnitt und die jeweilige weibliche Einkerbung passend zueinander ausgeformt, insbesondere ähnlich wie bei einer Nut-Feder-Verbindung. Die jeweilige weibliche Einkerbung kann dabei insbesondere als in z-Richtung durch die Leiterplatte hindurchgehende Nut ausgeführt sein.

Dank der beiden Längsabschnitte und der beiden weiblichen Einkerbungen ist eine besonders leichte und genaue Positionierung bzw. Zentrierung des vorgeschlagenen Verbindungsstücks bezüglich einer gewünschten Position des vorgeschlagenen Verbindungsstücks innerhalb eines Leistungsmoduls erreichbar. Insbesondere kann die oben bereits erwähnte Federwirkung bewirkt werden, wodurch die jeweilige Lasche beim Befestigen, bspw. Verschrauben, des Verbindungsstücks nachgibt und somit ausreichend Spiel für die Montage ermöglicht wird.

Bei einer weiteren vorteilhaften Ausgestaltung der Erfindung sind die jeweilige weibliche Einkerbung und der jeweilige, zugehörige männliche Laschenabschnitt derart ausgebildet, dass das jeweilige Verbindungsstück bei der Montage auf der Leiterplatte in positiver z-Richtung fixbar ist.

Insbesondere kann die genannte Fixierbarkeit des jeweiligen Verbindungsstücks auf der Leiterplatte in positiver z-Richtung durch eine passende Schrägung des jeweiligen männlichen Laschenabschnittes erreicht werden, wobei die Schrägung während der Montage dazu führt, dass sich die jeweilige Lasche in der jeweiligen Einkerbung leicht verklemmt bzw. mittels eines Kraftschlusses fixiert. Insb. wird die jeweilige Lasche in negativer z-Richtung bereits durch das Aufliegen auf jener Oberfläche der Leiterplatte fixiert, welche in positive z-Richtung weist, insb. wenn die beiden Laschen aus der jeweiligen weiblichen Einkerbung in positiver z-Richtung (ggf. schräg mit einer zusäztlichen positiven bzw. negativen x-Komponente) hinausragen. Weiterhin kann eine Fixierung des jeweiligen Verbindungsstücks in negativer z-Richtung bereits dadurch erreicht werden, dass die jeweilige Grundplatte in z-Richtung auf dem jeweiligen Halbleiter-Bauelement aufliegt, welches in negativer z-Richtung zur Leiterplatte versetzt angeordnet ist.

Durch die genannte Fixierbarkeit ist dabei insb. auch eine besonders leichte und genaue Positionierung bzw. Zentrierung des vorgeschlagenen Verbindungsstücks bezüglich einer gewünschten Position des vorgeschlagenen Verbindungsstücks innerhalb eines Leistungsmoduls erreichbar.

Bei einer weiteren vorteilhaften Ausgestaltung der Erfindung sind die jeweilige weibliche Einkerbung und der jeweilige, zugehörige männliche Laschenabschnitt derart ausgebildet, dass das Verbindungsstück bei der Montage auf der Leiterplatte bezüglich einer Drehung um die z-Richtung fixbar ist.

Bspw. kann eine Fixierbarkeit des jeweiligen Verbindungsstücks auf der Leiterplatte in x-Richtung durch eine passende Schrägung des jeweiligen männlichen Laschenabschnittes erreicht werden, die während der Montage dazu führt, dass sich die jeweilige Lasche in der jeweiligen Einkerbung leicht verklemmt bzw. mittels eines Kraftschlusses fixiert. Weiterhin kann eine Fixierbarkeit des jeweiligen Verbindungsstücks auf der Leiterplatte in y-Richtung dadurch erreicht werden, dass der jeweilige männliche Laschenabschnitt während der Montage des jeweiligen Verbindungsstücks auch in y-Richtung passend durch die jeweilige weibliche Einkerbung gehalten wird, bspw. indem sich die jeweilige Lasche in der jeweiligen Einkerbung auch in y-Richtung leicht verklemmt bzw. mittels eines Kraft- oder Formschlusses fixiert.

Indem das jeweilige Verbindungsstück dank der beiden männlichen Laschenabschnitte und der beiden weiblichen Einkerbungen sowohl in x-Richtung als auch in y-Richtung fixiert ist, liegt auch eine Fixierung des jeweiligen Verbindungsstückes bzgl. einer Drehung um die z-Richtung vor.

Bei einer weiteren vorteilhaften Ausgestaltung der Erfindung ragt das jeweilige Anschlusselement durch die Grundplatten-Aussparung und die jeweilige erste Leiterplatten-Aussparung in z-Richtung hindurch und ist mit dem jeweiligen Halbleiter-Bauelement verbunden.

Für diese Ausgestaltung des Leistungsmoduls wird die oben erläuterte Ausgestaltung des Verbindungsstücks mit der Grundplatten-Aussparung verwendet. Wie oben bereits erwähnt, kann das jeweilige Anschlusselement bspw. als Bolzen, Schraube, Stromschiene oder generell als stromführendes Element ausgeführt sein. Das jeweilige Anschlusselement wird dabei entlang der negativen z-Richtung durch die Grundplatten-Aussparung und die jeweilige erste Leiterplatten-Aussparung hindurchgeführt und mit dem jeweiligen Halbleiter-Bauelement verbunden. Insbesondere ist das jeweilige Anschlusselement dabei weiterhin im elektrischen Kontakt mit der erste elektrische Kontaktfläche des jeweiligen Verbindungsstücks, wobei die erste elektrische Kontaktfläche insb. an der Innenseite der Grundplatten-Aussparung oder an jener Oberfläche der Grundplatte angeordnet sein kann, welche in die positive z-Richtung weist.

Somit kann durch das jeweilige Anschlusselement eine Positionierung bzw. Zentrierung des vorgeschlagenen Verbindungsstücks bezüglich einer gewünschten Position des vorgeschlagenen Verbindungsstücks innerhalb eines Leistungsmoduls erreicht werden. Weiterhin erlaubt die Grundplatten-Aussparung insb. eine gute elektrische Kontaktierung des Verbindungsstücks, bspw. auch mit dem Halbleiter-Bauelement, und ermöglicht somit die Übertragung vergleichsweise großer elektrischer Ströme.

Bei einer weiteren vorteilhaften Ausgestaltung der Erfindung weist das Leistungsmodul weiterhin zumindest ein weiteres Anschlusselement und zumindest eine zweite Leiterplatten-Aussparung auf, wobei das jeweilige weitere Anschlusselement durch die Nebenplatten-Aussparung des jeweiligen Verbindungsstücks und die jeweilige zweite Leiterplatten-Aussparung in z-Richtung hindurchragt und mit dem jeweiligen Halbleiter-Bauelement verbunden ist.

Auch das jeweilige weitere Anschlusselement kann bspw. als Bolzen, Schraube, Stromschiene oder generell als stromführendes Element ausgeführt sein. Das jeweilige weitere Anschlusselement wird dabei entlang der negativen z-Richtung durch die Nebenplatten-Aussparung und die jeweilige zweite Leiterplatten-Aussparung hindurchgeführt und mit dem jeweiligen Halbleiter-Bauelement verbunden. Insbesondere ist das jeweilige weitere Anschlusselement dabei im elektrischen Kontakt mit der Nebenplatte des jeweiligen Verbindungsstücks, bspw. an der Innenseite der Nebenplatten-Aussparung oder an jener Oberfläche der Nebenplatte, welche in die positive z-Richtung weist.

Somit kann durch das jeweilige weitere Anschlusselement eine Positionierung bzw. Zentrierung des vorgeschlagenen Verbindungsstücks bezüglich einer gewünschten Position des vorgeschlagenen Verbindungsstücks innerhalb eines Leistungsmoduls erreicht werden. Weiterhin erlauben die jeweilige zweite Leiterplatten-Aussparung und die Nebenplatten-Aussparung des jeweiligen Verbindungsstücks insb. eine gute elektrische Kontaktierung des weiteren Anschlusselement, bspw. auch mit dem Halbleiter-Bauelement, und ermöglichen somit die Übertragung vergleichsweise großer elektrischer Ströme.

Bei einer weiteren vorteilhaften Ausgestaltung der Erfindung weist das Leistungsmodul weiterhin zumindest eine zweite Leiterplatten-Aussparung auf, wobei der jeweilige Verbindungsbügel durch die jeweilige zweite Leiterplatten-Aussparung in z-Richtung hindurchragt und mit dem jeweiligen Halbleiter-Bauelement verbunden ist.

Für diese Ausgestaltung des Leistungsmoduls wird die oben erläuterte Ausgestaltung des Verbindungsstücks mit dem zumindest einen Verbindungsbügel verwendet. Bei der jeweiligen zweiten Leiterplatten-Aussparung kann es sich bspw. um die bereits oben erläuterten zweiten Leiterplatten-Aussparungen handeln oder alternativ um separate zweite Leiterplatten-Aussparungen.

Bspw. ist der jeweilige Verbindungsbügel als Lötpin ausgestaltet und wird mittels Löten mit dem jeweiligen Halbleiter-Bauelement verbunden.

Der jeweilige Verbindungsbügel ermöglicht eine Positionierung bzw. Zentrierung des vorgeschlagenen Verbindungsstücks bezüglich einer gewünschten Position des vorgeschlagenen Verbindungsstücks innerhalb eines Leistungsmoduls. Weiterhin erlaubt der jeweilige Verbindungsbügel insb. eine gute elektrische Kontaktierung des jeweiligen Verbindungsstücks mit dem Halbleiter-Bauelement und ermöglicht somit die Übertragung vergleichsweise großer elektrischer Ströme.

Bei dem vorgeschlagenen Verbindungsstück, dem vorgeschlagenen Leistungsmodul sowie dem vorgeschlagenen elektrischen Gerät können dabei die genannte x-, y- und z-Richtungen im Raum gedreht werden, wobei auch gleichwertige jeweilige Ausgestaltungen denkbar sind, welche bezüglich einer oder mehrerer Achsen gespiegelt sind. Bspw. können die Grundplatte, dass Übergangsstück und die Nebenplatte derart angeordnet sein, dass in positiver y-Richtung oder gleichwertig in negativer y-Richtung zunächst die Nebenplatte, dann das Übergangsstück und schließlich die Grundplatte angeordnet sind, also eine Spiegelung bezüglich der x-Achse vorliegt.

Im Vergleich zu bisherigen Lösungen sind insb. die Laschen hervorzuheben. Denn die Einsatzmöglichkeit der bisherigen Standartlösungen ist begrenzt und oftmals ist bei den bisherigen Lösungen in der Fertigung bzw. bei der Montage zusätzliches Equipment notwendig, bspw. zusätzliche Halterungen oder Positionierhilfen, etc. Derartiges Equipment ist jedoch teuer und kann aus Prozesssicht nicht immer eingesetzt werden. Dank des vorgeschlagenen Verbindungsstücks, des vorgeschlagenen Leistungsmoduls und des vorgeschlagenen elektrischen Geräts und insb. mit der Ergänzung der Positionslaschen kann das Verwendungsfeld erweitert werden und die Fertigungsprozesse vereinfachen sich erheblich.

### Exemplarische Ausführungsbeispiele der Zeichnungen

Im Folgenden wird die Erfindung anhand der in den Figuren dargestellten Ausführungsbeispiele näher beschrieben und er-läutert. Es zeigen:
- Fig. 1-4: ein erstes Ausführungsbeispiel des vorgeschlagenen Verbindungsstücks,
- Fig. 5-8: ein zweites Ausführungsbeispiel des vorgeschlagenen Verbindungsstücks,
- Fig. 9-13: räumliche Darstellungen eines Ausschnitts eines ersten bis fünften Ausführungsbeispiels des vorgeschlagenen Leistungsmoduls, und
- Fig. 14: ein Ausführungsbeispiel des vorgeschlagenen elektrischen Geräts.

### Detaillierte Beschreibung der Ausführungsbeispiele

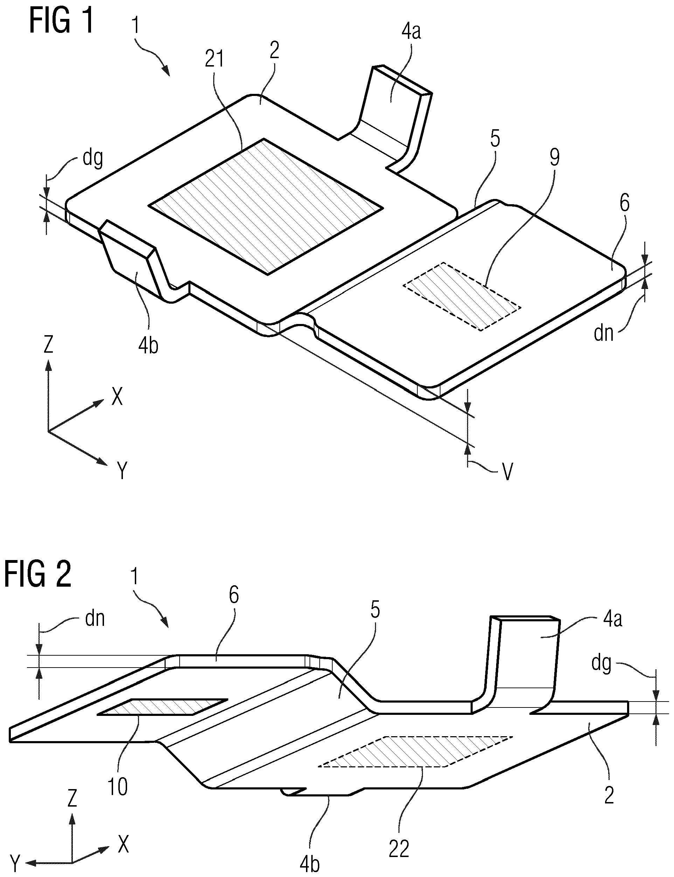

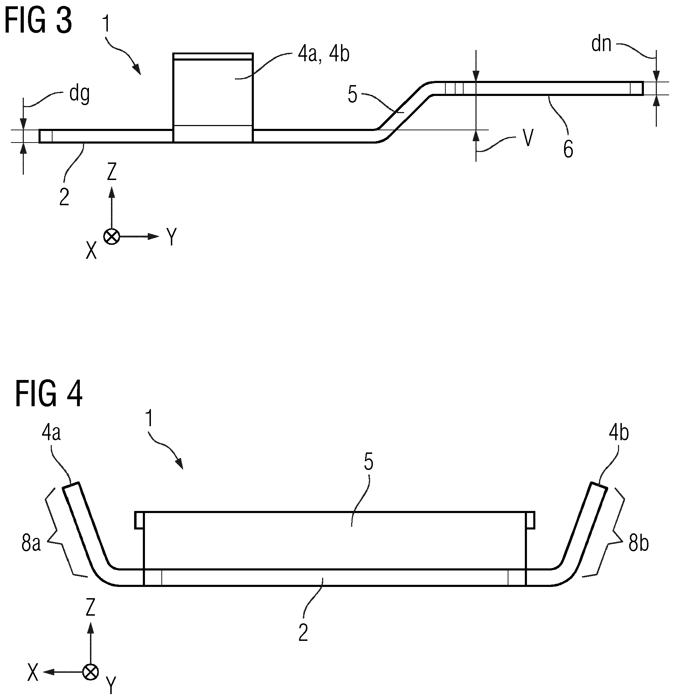

Die Figuren 1 bis 4 zeigen ein erstes Ausführungsbeispiel des vorgeschlagenen Verbindungsstücks 1, wobei die Figuren 1 und 2 zwei perspektivische Ansichten zeigen und die Figuren 3 und 4 zwei Querschnitte durch das Verbindungsstück 1. Gleiche Bezugszeichen bezeichnen dabei gleiche Gegenstände.

Das Verbindungsstück 1 ist zum Verbinden zumindest zweier elektrischer Kontakte geeignet und weist hierfür eine Grundplatte 2 auf, welche sich in der x-y-Ebene erstreckt und eine Dicke dg in z-Richtung aufweist. Die Grundplatte 2 weist eine erste elektrische Kontaktfläche 21 sowie zwei Laschen 4a, 4b auf, von denen die erste Lasche 4a in positiver x-Richtung und die zweite Lasche 4b in negativer x-Richtung aus der Grundplatte 2 herausragt. Dabei ragen die beiden Laschen 4a, 4b weiterhin in positiver z-Richtung aus der Grundplatte 2 heraus. Im Rahmen des Ausführungsbeispiels ist die erste elektrische Kontaktfläche 21 an jener Seite der Grundplatte 2 angeordnet, welche in die positive z-Richtung weist.

Weiterhin weist das Verbindungsstück 1 ein Übergangsstück 5 auf, welches in Verlängerung in y-Richtung an der Grundplatte 2 angeordnet ist, wobei das Übergangsstück 5 im Rahmen des Ausführungsbeispiels in Verlängerung in positiver y-Richtung an der Grundplatte 2 angeordnet ist.

Das Verbindungsstück 1 weist weiterhin eine Nebenplatte 6 auf, welche in Verlängerung in y-Richtung an dem Übergangsstück 5 angeordnet ist. Dabei ist die Nebenplatte 6 über das Übergangsstück 5 mit der Grundplatte 2 verbunden. Im Rahmen des Ausführungsbeispiels sind in positiver y-Richtung somit zunächst die Grundplatte 2, dann das Übergangsstück 5 und schließlich die Nebenplatte 6 angeordnet, wobei auch eine umgekehrte Reihenfolge denkbar ist, wie bereits oben erwähnt. Die Nebenplatte 6 erstreckt sich in der x-y-Ebene und ist um einen Versatz V in positiver z-Richtung gegenüber der Grundplatte 2 versetzt ist. Dabei weist die Nebenplatte 6 eine Dicke dn in z-Richtung auf. Weiterhin weist die Nebenplatte 6 eine zweite elektrische Kontaktfläche 10 aufweist, welche im Rahmen des Ausführungsbeispiels an jener Seite der Nebenplatte 6 angeordnet, welche in die negative z-Richtung weist.

Dabei weist die erste Lasche 4a einen ersten männlichen Laschenabschnitt 8a auf, welcher zumindest abschnittsweise schräg in positiver x-Richtung und positiver z-Richtung verläuft. Entsprechend weist die zweite Lasche 4b einen zweiten männlichen Laschenabschnitt 8b auf, welcher zumindest abschnittsweise schräg in negativer x-Richtung und positiver z-Richtung verläuft.

Dank der beiden Längsabschnitte 8 und, 8b ist eine besonders leichte und genaue Positionierung bzw. Zentrierung des Verbindungsstücks 1 bezüglich einer gewünschten Position des Verbindungsstücks 1 innerhalb eines Leistungsmoduls 12 erreichbar. Dabei tragen die beiden elektrischen Kontaktflächen 21 und 10 dazu bei, dass das Verbindungsstück 1 die Übertragung vergleichsweise großer elektrischer Ströme ermöglicht.

Optional kann die Grundplatte 2 eine in negative z-Richtung weisende dritte elektrische Kontaktfläche 22 aufweisen. Weiterhin kann die die Nebenplatte 6 optional eine in positive z-Richtung weisende Transportoberfläche 9 aufweisen, welche zum vollautomatischen Bestücken auf Leiterplatten oder anderen Trägersubstraten mittels eines Bestückungsautomaten geeignet ist.

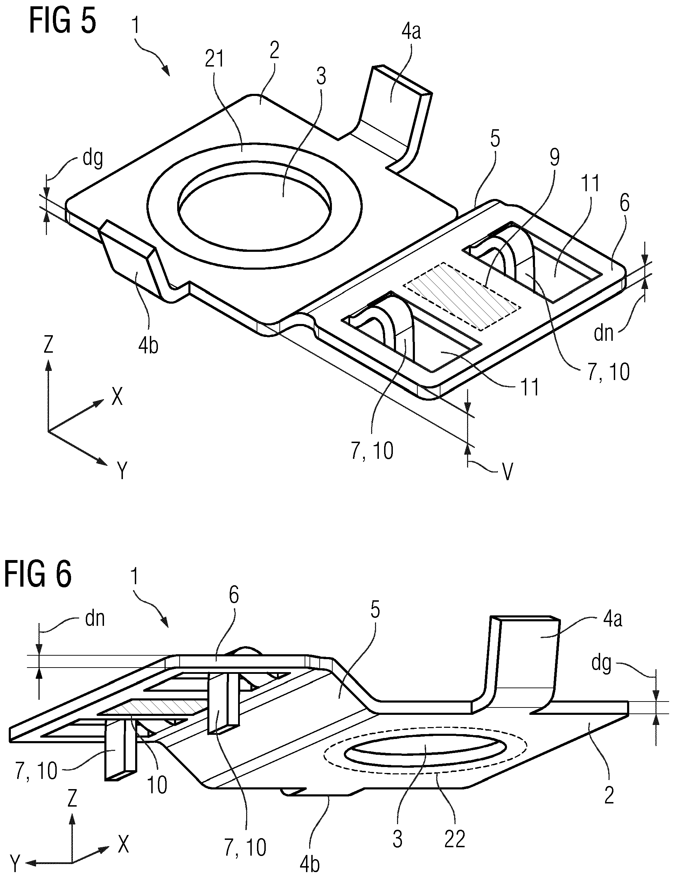

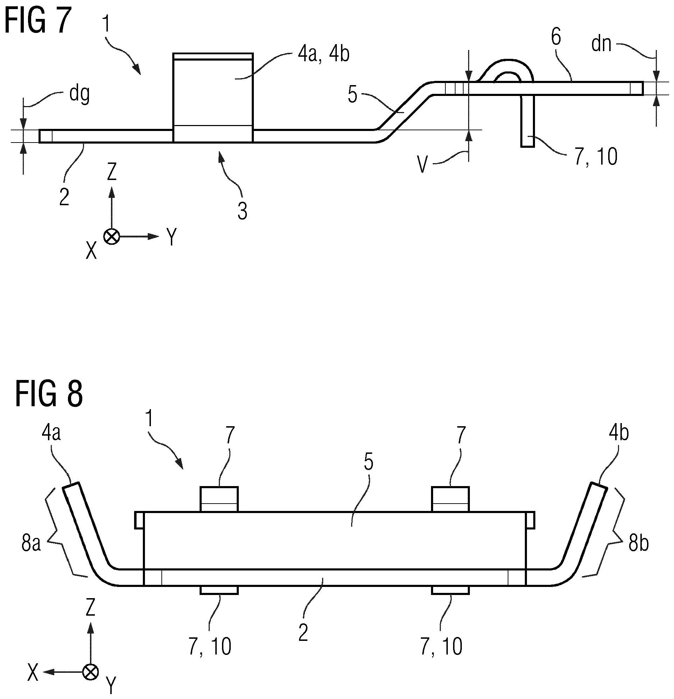

Die Figuren 5 bis 8 zeigen ein zweites Ausführungsbeispiel des vorgeschlagenen Verbindungsstücks 1, wobei die Figuren 5 und 6 wiederum zwei perspektivische Ansichten zeigen und die Figuren 7 und 8 wiederum zwei Querschnitte durch das Verbindungsstück 1.

Im Unterschied zum ersten Ausführungsbeispiel weist die Grundplatte 2 des Verbindungsstücks 1 gemäß dem zweiten Ausführungsbeispiel eine in z-Richtung durchgehende Grundplatten-Aussparung 3 auf.

Durch die Grundplatten-Aussparung 3 kann bspw. ein Verbindungselement 14 durch die Grundplatte 2 hindurchgeführt werden, wobei das Verbindungselement 14 dabei die Grundplatte 2 zumindest an der ersten elektrischen Kontaktfläche 21 berührt und damit mit der Grundplatte 2 elektrisch kontaktiert ist. Dabei umfasst die erste elektrische Kontaktfläche 21 die Innenseite der Grundplatten-Aussparung 3 sowie einen Teil jener Oberfläche der Grundplatte 2, welcher in die positive z-Richtung weist und um die Grundplatten-Aussparung 3 herum angeordnet ist.

Die Grundplatten-Aussparung 3 erlaubt insb. eine gute elektrische Kontaktierung des Verbindungsstücks 1 und ermöglicht somit die Übertragung vergleichsweise großer elektrischer Ströme.

Ebenfalls im Unterschied zum ersten Ausführungsbeispiel weist die Nebenplatte 6 des Verbindungsstücks 1 gemäß dem zweiten Ausführungsbeispiel zwei Verbindungsbügel 7 auf, welche jeweils in negativer z-Richtung aus der übrigen Nebenplatte 6 herausragen und welche zumindest abschnittsweise von der zweiten elektrischen Kontaktfläche 10 umfasst sind.

Vorzugsweise ragt der jeweilige Verbindungsbügel 7 soweit aus der übrigen Nebenplatte 6 in negativer z-Richtung heraus, dass der jeweilige Verbindungsbügel 7 durch eine Leiterplatte 15 des Leistungsmoduls 12 hindurch ein Halbleiter-Bauelement 13 des Leistungsmoduls 12 elektrisch kontaktieren kann, wobei bei einem derartigen Leistungsmodul 12 in negativer z-Richtung zunächst die flach ausgestaltete, übrige Nebenplatte 6, dann die Leiterplatte 15 und schließlich das Halbleiter-Bauelement 13 des Leistungsmoduls 12 angeordnet sind.

Um den jeweiligen Verbindungsbügel 7 herum weist die Nebenplatte 6 in der x-y-Ebene eine U-förmige Nebenplatten-Aussparung 11 auf. Beispielsweise kann der jeweilige Verbindungsbügel 7 mittels Stanzen und Biegen aus der Nebenplatte 6 ausgeformt werden, wobei die jeweilige U-förmige Nebenplatten-Aussparung 11 um den jeweiligen Verbindungsbügel 7 herum ausgestanzt wird. Der jeweilige Verbindungsbügel kann dabei optional als Lötpin ausgestaltet sein.

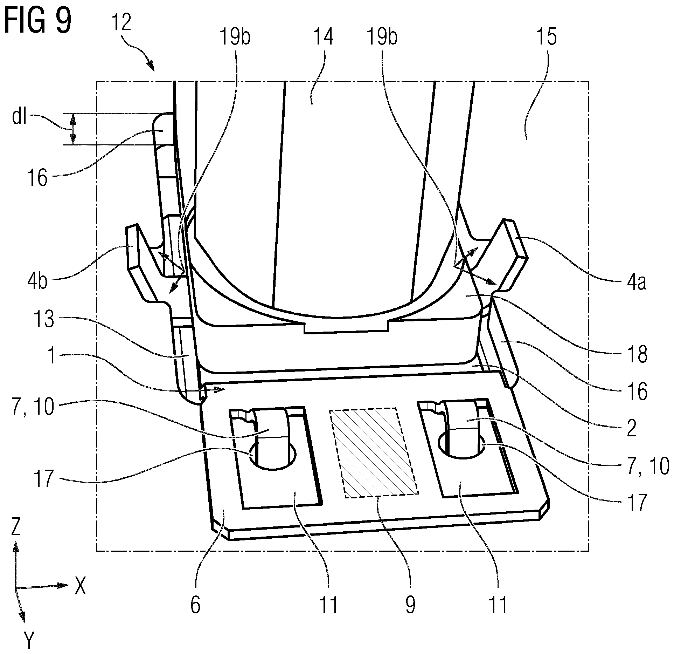

Die Figur 9 zeigt eine räumliche Darstellung eines Ausschnitts eines ersten Ausführungsbeispiels des vorgeschlagenen Leistungsmoduls 12.

Das Leistungsmodul 12 weist eine Leiterplatte 15 auf, welche sich in der x-y-Ebene erstreckt und eine Dicke dl in z-Richtung aufweist. Die Leiterplatte 15 weist dabei zumindest eine erste Leiterplatten-Aussparung 16 auf. Weiterhin weist das Leistungsmodul 12 ein Halbleiter-Bauelement 13 auf, welches sich jeweils in der x-y-Ebene erstreckt und in negativer z-Richtung versetzt zur Leiterplatte 15 angeordnet ist. Ferner weist das Leistungsmodul 12 ein Verbindungsstück 1 auf, welches dem oben erläuterten, zweiten Ausführungsbeispiel des Verbindungsstücks 1 ähnlich ist. Schließlich weist das Leistungsmodul 12 ein Anschlusselement 14 auf.

Das Verbindungsstück 1 ist dabei derart angeordnet ist, dass dessen Grundplatte 2 in der ersten Leiterplatten-Aussparung 16 angeordnet ist und die jeweiligen beiden Laschen 4a, 4b abschnittsweise auf der Leiterplatte 15 in z-Richtung aufliegen. Dabei weist die Leiterplatte 15 dort eine erste weibliche Einkerbung 19a in positiver x-Richtung auf, wo der erste männliche Laschenabschnitt 8a die Leiterplatte 15 berührt, und dort eine zweite weibliche Einkerbung 19b in negativer x-Richtung auf, wo der zweite männliche Laschenabschnitt 8b die Leiterplatte 15 berührt. Dank der beiden Längsabschnitte 8a und 8b und der beiden weiblichen Einkerbungen 19a und 19b ist eine besonders leichte und genaue Positionierung bzw. Zentrierung des vorgeschlagenen Verbindungsstücks 1 bezüglich einer gewünschten Position des vorgeschlagenen Verbindungsstücks 1 innerhalb eines Leistungsmoduls 12 erreichbar.

Weiterhin ist das Verbindungsstück 1 ist dabei derart angeordnet ist, dass die jeweilige Nebenplatte 6 zumindest abschnittsweise auf der Leiterplatte 15 in z-Richtung aufliegt, das Anschlusselement 14 mit der ersten elektrischen Kontaktfläche 21 verbunden ist, und die zweite elektrische Kontaktfläche 10 mit dem Halbleiter-Bauelement 13 verbunden ist. Dabei kann das Anschlusselement 14 bspw. über eine Stromschiene 18 mit der ersten elektrischen Kontaktfläche 21 verbunden sein.

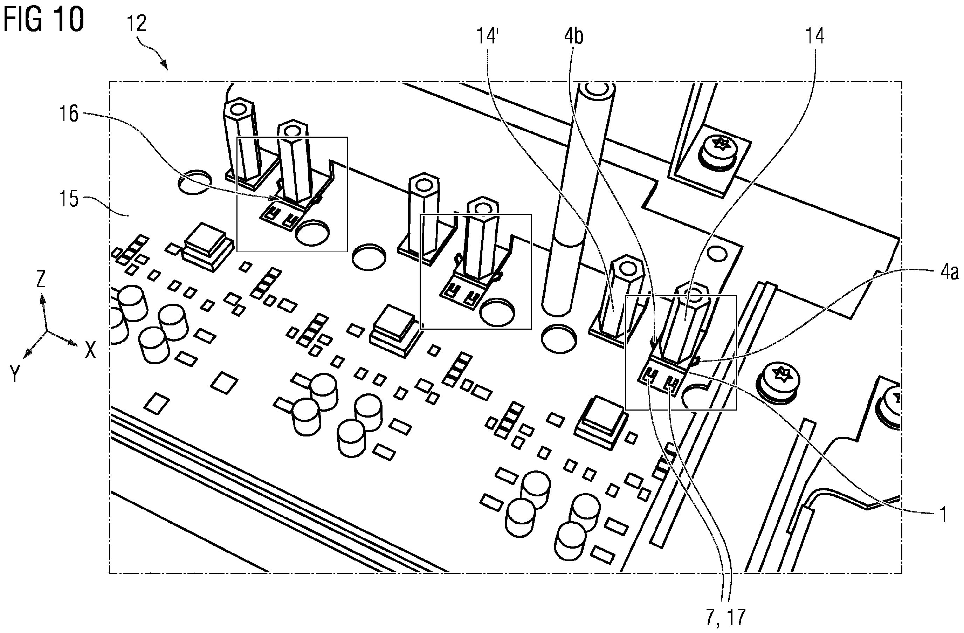

Die Figur 10 zeigt eine räumliche Darstellung eines Ausschnitts eines zweiten Ausführungsbeispiels des vorgeschlagenen Leistungsmoduls 12. Bei dem weiten Ausführungsbeispiel des vorgeschlagenen Leistungsmoduls 12 sind mehrere Anordnungen wie in der Figur 9 dargestellt vorhanden, welche jeweils mit einem Rahmen hervorgehoben sind.

Bei dem zweiten Ausführungsbeispiel des vorgeschlagenen Leistungsmoduls 12 ist neben einem jeweiligen Anschlusselement 14, bspw. für den negativen Anschluss DCN des Halbleiter-Bauelements 13, ein jeweiliges weiteres Anschlusselement 14' angeordnet. Dabei ist das jeweilige weitere Anschlusselement 14`in negativer x-Richtung zum jeweiligen Anschlusselement 14 versetzt angeordnet und bspw. für den positiven Anschluss DCP des Halbleiter-Bauelements 13 vorgesehen.

In diesem Zusammenhang sind die Anordnung und Ausgestaltung des jeweiligen Verbindungsstücks 1 besonders vorteilhaft:
- Das jeweiligen Verbindungsstück 1 ermöglicht einen flachen Aufbau in z-Richtung, so dass ein verwendetes Schienenkonzept nicht grundlegend verändert werden muss.
- Der Abstand (insb. in x-Richtung) zwischen dem jeweiligen Anschlusselement 14 ("DCN") und dem jeweiligen weiteren Anschlusselement 14` ("DCP") bleibt auch bei Verwendung des jeweiligen Verbindungsstücks 1 erhalten, so dass bspw. eine (insb. 7 mm lange) Luft- und Kriechstrecke nicht unterschritten wird.
- Das Leistungsmodul 12 ist auch bei Verwendung des jeweiligen Verbindungsstücks 1 weiterhin ohne Bestückhilfe, wie Halterungen, Positionierhilfen, etc., fertigbar.
- Dank des jeweiligen Verbindungsstücks 1 können unterschiedliche Höhenniveaus (in z-Richtung) der unterschiedlichen Kontaktflächen ausgleichen werden.

Insbesondere wenn an dem jeweiligen Anschlusselement 14 und/oder dem jeweiligen weiteren Anschlusselement 14' elektrische Ströme oder Spannungen gemessen werden, tragen die Anordnung und Ausgestaltung des jeweiligen Verbindungsstücks 1 dazu bei, das Massekonzept zu verbessern, um Störungen der Messsignale zu unterbinden. Störeinwirkungen sind bei anderen Lösungen insbesondere zwischen dem jeweiligen Anschlusselement 14 ("DCN") und dem jeweiligen weiteren Anschlusselement 14` ("DCP") des Halbleiter-Bauelements 13 zu messen. Insbesondere helfen die Anordnung und Ausgestaltung des jeweiligen Verbindungsstücks 1 eine direkte Anbindung des jeweiligen Anschlusselements 14 ("DCN") mit einer Massefläche der Leiterplatte 15 oder des Leistungsmoduls 12 zu realisieren.

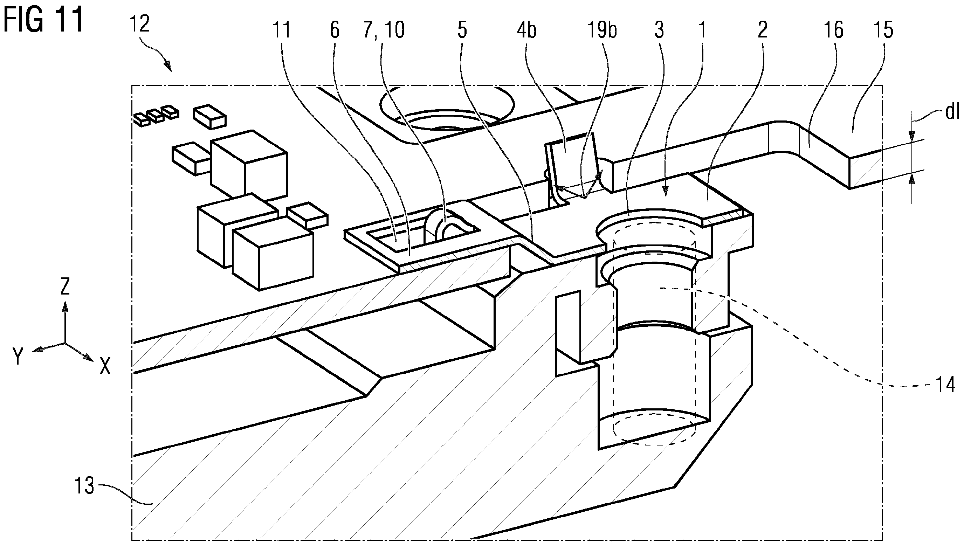

Die Figur 11 zeigt eine räumliche Darstellung eines Ausschnitts eines dritten Ausführungsbeispiels des vorgeschlagenen Leistungsmoduls 12. Das dritte Ausführungsbeispiel hat dabei Ähnlichkeiten mit dem ersten Ausführungsbeispiel des vorgeschlagenen Leistungsmoduls 12, wobei ein Zwischenschritt während der Montage des Leistungsmoduls 12 gezeigt wird. Noch zu montieren ist das Anschlusselement 14, welches daher gestrichelt angedeutet ist.

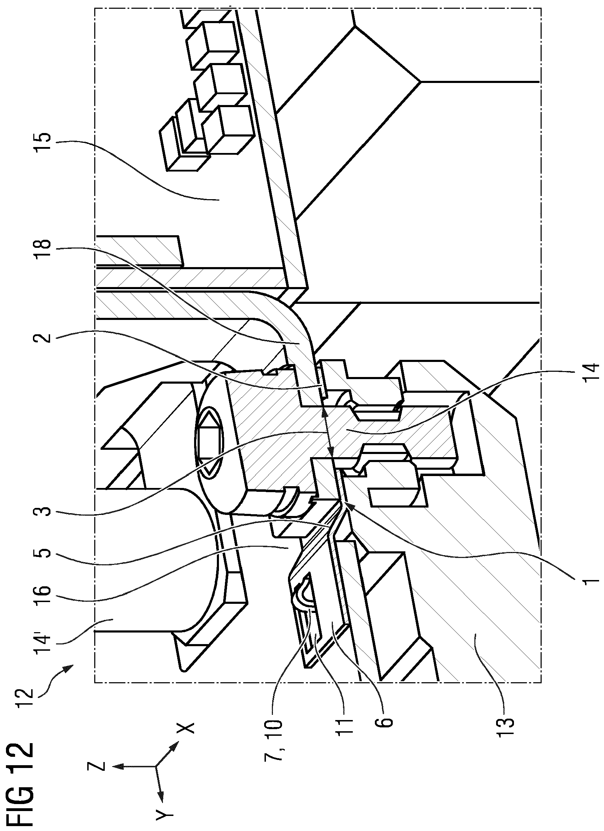

Die Figur 12 zeigt eine räumliche Darstellung eines Ausschnitts eines vierten Ausführungsbeispiels des vorgeschlagenen Leistungsmoduls 12. Das vierte Ausführungsbeispiel hat dabei Ähnlichkeiten mit dem dritten Ausführungsbeispiel des vorgeschlagenen Leistungsmoduls 12, wobei nun das das Anschlusselement 14 montiert ist. Weiterhin ist das weitere Anschlusselement 14' dargestellt, das oben im Zusammenhang mit dem zweiten Ausführungsbeispiel des vorgeschlagenen Leistungsmoduls 12 erläutert ist.

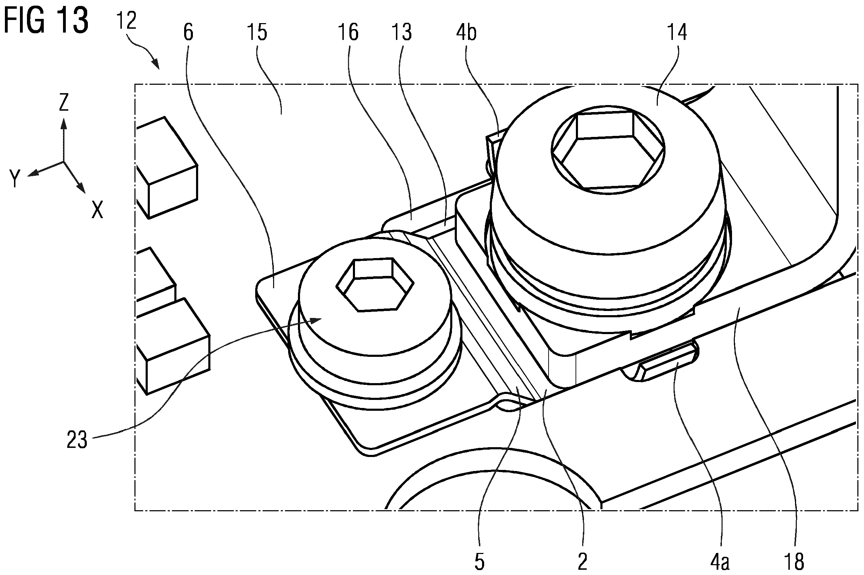

Die Figur 13 zeigt eine räumliche Darstellung eines Ausschnitts eines fünften Ausführungsbeispiels des vorgeschlagenen Leistungsmoduls 12. Das fünfte Ausführungsbeispiel hat dabei Ähnlichkeiten mit dem vierten Ausführungsbeispiel des vorgeschlagenen Leistungsmoduls 12, wobei die Nebenplatte 6 keine Verbindungsbügel 7 aufweist. Vielmehr ist ein weiteres Anschlusselement 23 durch eine Nebenplatten-Aussparung 11 montiert.

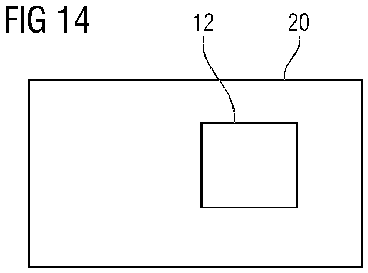

Fig. 14 zeigt ein Ausführungsbeispiel des vorgeschlagenen elektrischen Geräts 20, das eines der vorgeschlagenen Leistungsmodule 12 aufweist.

## Patentansprüche

1. Verbindungsstück (1) zum Verbinden zumindest zweier elektrischer Kontakte aufweisend:
• eine Grundplatte (2), welche sich in der x-y-Ebene erstreckt und eine Dicke dg in z-Richtung aufweist,
wobei die Grundplatte (2) zumindest abschnittsweise eine erste elektrische Kontaktfläche (21) aufweist,
wobei die Grundplatte (2) zwei Laschen (4a, 4b) aufweist, von denen die erste Lasche (4a) in positiver x-Richtung und die zweite Lasche (4b) in negativer x-Richtung aus der Grundplatte (2) herausragt,
wobei die beiden Laschen (4a, 4b) weiterhin in positiver z-Richtung aus der Grundplatte (2) herausragen,
• ein Übergangsstück (5), welches in Verlängerung in y-Richtung an der Grundplatte (2) angeordnet ist, und
• eine Nebenplatte (6),
wobei die Nebenplatte (6) in Verlängerung in y-Richtung an dem Übergangsstück (5) angeordnet ist,
wobei die Nebenplatte (6) über das Übergangsstück (5) mit der Grundplatte (2) verbunden ist,
wobei die Nebenplatte (6) sich in der x-y-Ebene erstreckt, um einen Versatz V in positiver z-Richtung gegenüber der Grundplatte (2) versetzt ist und eine Dicke dn in z-Richtung aufweist, und
wobei die Nebenplatte (6) zumindest abschnittsweise eine zweite elektrische Kontaktfläche (10) aufweist.

2. Verbindungsstück (1) nach Anspruch 1,
wobei die erste Lasche (4a) einen ersten männlichen Laschenabschnitt (8a) aufweist, welcher zumindest abschnittsweise schräg in positiver x-Richtung und positiver z-Richtung verläuft und wobei die zweite Lasche (4b) einen zweiten männlichen Laschenabschnitt (8b) aufweist, welcher zumindest abschnittsweise schräg in negativer x-Richtung und positiver z-Richtung verläuft.

3. Verbindungsstück (1) nach einem der vorhergehenden Ansprüche,
wobei die Grundplatte (2) eine in z-Richtung durchgehende Grundplatten-Aussparung (3) aufweist.

4. Verbindungsstück (1) nach einem der vorhergehenden Ansprüche,
wobei die Grundplatte (2) zumindest abschnittsweise eine in negative z-Richtung weisende dritte elektrische Kontaktfläche (22) aufweist.

5. Verbindungsstück (1) nach einem der vorhergehenden Ansprüche,
wobei die Nebenplatte (6) zumindest abschnittsweise eine in positive z-Richtung weisende Transportoberfläche (9) aufweist, welche zum vollautomatischen Bestücken auf Leiterplatten oder anderen Trägersubstraten mittels eines Bestückungsautomaten geeignet ist.

6. Verbindungsstück (1) nach einem der vorhergehenden Ansprüche,
wobei die Nebenplatte (6) zumindest einen Verbindungsbügel (7, 10) aufweist, welcher jeweils in negativer z-Richtung aus der Nebenplatte (6) herausragt und welcher zumindest abschnittsweise von der zweiten elektrischen Kontaktfläche (10) umfasst ist.

7. Verbindungsstück (1) nach einem der vorhergehenden Ansprüche,
wobei die Nebenplatte (6) zumindest eine in z-Richtung durchgehende zweite Nebenplatten-Aussparung (11) aufweist.

8. Leistungsmodul (12) aufweisend:
• eine Leiterplatte (15), welche sich in der x-y-Ebene erstreckt und eine Dicke dl in z-Richtung aufweist,
wobei die Leiterplatte (15) zumindest eine erste Leiterplatten-Aussparung (16) aufweist,
• zumindest ein Halbleiter-Bauelement (13), welches sich jeweils in der x-y-Ebene erstreckt und in negativer z-Richtung versetzt zur Leiterplatte (15) angeordnet ist,
• zumindest ein Verbindungsstück (1) nach einem der vorhergehenden Ansprüche und
• zumindest ein Anschlusselement (14),
wobei das jeweilige Verbindungsstück (1) derart angeordnet ist, dass
• die jeweilige Grundplatte (2) in der jeweiligen ersten Leiterplatten-Aussparung (16) angeordnet ist und die jeweiligen beiden Laschen (4a, 4b) jeweils zumindest abschnittsweise auf der Leiterplatte (15) in z-Richtung aufliegen,
• die jeweilige Nebenplatte (6) zumindest abschnittsweise auf der Leiterplatte (15) in z-Richtung aufliegt,
• das jeweilige Anschlusselement (14) mit der jeweiligen ersten elektrischen Kontaktfläche (21) verbunden ist, und
• die jeweilige zweite elektrische Kontaktfläche (10) mit dem jeweiligen Halbleiter-Bauelement (13) verbunden ist.

9. Leistungsmodul (12) nach Anspruch 8 aufweisend zumindest ein Verbindungsstück (1) zumindest nach Anspruch 2,
wobei die Leiterplatte (15) dort eine erste weibliche Einkerbung (19a) in positiver x-Richtung aufweist, wo der erste männliche Laschenabschnitt (8a) die Leiterplatte (15) berührt, und
wobei die Leiterplatte (15) dort eine zweite weibliche Einkerbung (19b) in negativer x-Richtung aufweist, wo der zweite männliche Laschenabschnitt (8b) die Leiterplatte (15) berührt.

10. Leistungsmodul (12) nach Anspruch 9,
wobei die jeweilige weibliche Einkerbung (19a, 19b) und der jeweilige, zugehörige männliche Laschenabschnitt (8a, 8b) derart ausgebildet sind, dass das jeweilige Verbindungsstück (1) bei der Montage auf der Leiterplatte (15) in positiver z-Richtung fixbar ist.

11. Leistungsmodul (12) nach Anspruch 9 oder 10,
wobei die jeweilige weibliche Einkerbung (19a, 19b) und der jeweilige, zugehörige männliche Laschenabschnitt (8a, 8b) derart ausgebildet sind, dass das Verbindungsstück (1) bei der Montage auf der Leiterplatte (15) bezüglich einer Drehung um die z-Richtung fixbar ist.

12. Leistungsmodul (12) nach einem der Ansprüche 8 bis 11 aufweisend zumindest ein Verbindungsstück (1) zumindest nach Anspruch 3,
wobei das jeweilige Anschlusselement (14) durch die Grundplatten-Aussparung (3) und die jeweilige erste Leiterplatten-Aussparung (16) in z-Richtung hindurchragt und mit dem jeweiligen Halbleiter-Bauelement (13) verbunden ist.

13. Leistungsmodul (12) nach einem der Ansprüche 8 bis 12,
weiterhin aufweisend zumindest ein weiteres Anschlusselement (23) und zumindest eine zweite Leiterplatten-Aussparung (17),
wobei das jeweilige weitere Anschlusselement (23) durch die Nebenplatten-Aussparung (11) des jeweiligen Verbindungsstücks (1) und die jeweilige zweite Leiterplatten-Aussparung (17) in z-Richtung hindurchragt und mit dem jeweiligen Halbleiter-Bauelement (13) verbunden ist.

14. Leistungsmodul (12) nach einem der Ansprüche 8 bis 13 aufweisend zumindest ein Verbindungsstück (1) zumindest nach Anspruch 6,
weiterhin aufweisend zumindest eine zweite Leiterplatten-Aussparung (17),
wobei der jeweilige Verbindungsbügel (7, 10) durch die jeweilige zweite Leiterplatten-Aussparung (17) in z-Richtung hindurchragt und mit dem jeweiligen Halbleiter-Bauelement (13) verbunden ist.

15. Elektrisches Gerät (20), insbesondere Umrichter, umfassend zumindest ein Leistungsmodul (12), vorzugsweise zumindest drei Leistungsmodule (12), nach einem der Ansprüche 8 bis 14.
